# EUROPÄISCHE PATENTSCHRIFT

(11) **EP 2 134 884 B1**
(45) Veröffentlichungstag und Bekanntmachung des Hinweises auf die Patenterteilung: **01.08.2012**
(21) Anmeldenummer: 08736109.3
(22) Anmeldetag: 11.04.2008
(51) Int. Cl.: C23C 16/02, C23C 16/26, C23C 16/455

(54) **VERFAHREN ZUM AUFBRINGEN EINER HOCHFESTEN BESCHICHTUNG AUF WERKSTÜCKE UND/ODER WERKSTOFFE**
METHOD FOR THE APPLICATION OF A HIGH-STRENGTH COATING TO WORKPIECES AND/OR MATERIALS
PROCÉDÉ D'APPLICATION D'UN REVÊTEMENT À RÉSISTANCE ÉLEVÉE SUR DES PIÈCES À USINER ET/OU DES MATÉRIAUX

(30) Priorität: 13.04.2007 DE 102007017891; 04.10.2007 DE 102007047629
(43) Veröffentlichungstag der Anmeldung: 23.12.2009
(73) Patentinhaber: Stein, Ralf, 44229 Dortmund (DE)
(72) Erfinder: NÖLL, Oliver, 34613 Schwalmtal (DE)
(74) Vertreter: Michalski Hüttermann & Partner
(86) Internationale Anmeldenummer: PCT/EP2008/054394
(87) Internationale Veröffentlichungsnummer: WO 2008/125607

(56) Entgegenhaltungen:
- WO-A-00/15869
- WO-A-2006/005200
- DE-A1- 10 018 143
- DE-A1- 10 213 661
- DE-A1- 19 808 180

## Beschreibung

Die vorliegende Erfindung betrifft ein Verfahren zum Aufbringen einer Beschichtung auf Werkstücke und/oder Werkstoffe gemäß dem Oberbegriff des Anspruchs 1.

### Stand der Technik

Um die Standzeiten und die Reibungskoeeffizienten von Werkstücken und Werkstoffen zu verbessern, werden seit längerer Zeit schon Oberflächenbeschichtungen eingesetzt. Hier kommen insbesondere kohlenstoffhaltige Beschichtungen ("diamond like carbon") Beschichtungen zum Einsatz, aber auch Beschichtungen aus Siliziumoxiden (SiOₓ) oder anderen Werkstoffen.

Solche Beschichtungen werden insbesondere durch Plasmabeschichtungsverfahren wie das "Plasma Enhanced Chemical Vapour Deposition"-Verfahren (PECVD) - auf Werkstücke und/oder Werkstoffe aufgebracht.

Dieses Verfahren ist eine Sonderform der "Chemical Vapour Deposition" (CVD), bei der die Abscheidung von dünnen Schichten durch chemische Reaktion in einer Unterdruckkammer erfolgt; hierbei liegt das Material, mit welchem die Beschichtung ausgeführt werden soll, in der Gas- oder Dampfphase vor.

Zusätzlich wird der Prozess bei PECVD durch ein Plasma unterstützt. Dazu wird zwischen dem zu beschichtenden Substrat und einer Gegenelektrode ein starkes elektrisches Feld angelegt, durch das ein Plasma gezündet wird. Das Plasma bewirkt ein Aufbrechen der Bindungen des Reaktionsgases und zersetzt es in Ionen bzw. Radikale, die sich auf dem Substrat niederschlagen und dort die chemische Abscheidereaktion bewirken. Dadurch kann eine höhere Abscheiderate bei geringerer Abscheidetemperatur als mit CVD erreicht werden.

Kohlenstoff- und/oder Siliziumoxidhaltige Beschichtungen, insbesondere solche aus DLC, zeichnen sich durch eine große Härte, eine hohe Widerstandsfähigkeit gegen tribologische Belastungen sowie eine hohe Glätte verbunden mit einem niedrigem Reibkoeffizienten im Bereich von µ = 0,1 aus.

Dieser Beschichtungstyp eignet sich daher insbesondere für Stanz-, Schneid-, Bohr- und Schraubwerkzeuge, Zerspanungswerkzeuge, Prothesen, Kugel- oder Wälzlager, Zahnräder, Ritzel, Antriebsketten, Ton- und Antriebseinheiten in magnetischen Aufzeichnungsgeräten, sowie chirurgische und zahnchirurgische Instrumente. Insbesondere eignet er sich für Messer mit wechselbaren Klingen, so z.B. chirurgische Messer, und/oder Klingen und/oder Messer für industrielle Anwendungen.

Die zu beschichtenden Werksticke und/oder Werkstoffe können insbesondere aus Metallen, Keramik oder Kunststoffen bestehen, solche Werkstoffe aufweisen, oder aber Gemische oder Verbünde aus besagten Werkstoffen darstellen.

In vielen Fällen haften die besagten Beschichtungen jedoch nur sehr schlecht auf den genannten Werkstücken und/oder Werkstoffen. Die Gründe hierfür sind mannigfaltig:
1. Da PECVD-Beschichtungen im Vakuum in einer entsprechenden Vakuumkammer erfolgen, erfahren die zu beschichtenden Werkstücke und/oder Werkstoffe während der Evakuierung der Kammer eine minimale Volumenzunahme, da sie - obwohl aus eigentlich inkompressiblen Feststoffen bestehend - häufig gasgefüllte Mikrokavitäten aufweisen, die bei der Evakuierung ihr Volumen vergrößern. Nach Auftrag der Beschichtung werden die Werkstücke und/oder Werkstoffe wieder unter atmosphärischen Druck gesetzt, was zu einem schrumpfen letzterer führt. Dieses Schrumpfen kann zu einer Ablösung der Beschichtung führen, wenn diese nicht ausreichend auf der Oberfläche der Werkstücke und/oder Werkstoffe haften
2. Häufig weisen die zu beschichtenden Werkstücke und/oder Werkstoffe eine andere Eigenspannung auf als die Beschichtung. Dies ist auf die Art der Herstellung zurückzuführen. So leiden Hartmetall-Werkstücke bzw. Werkstoffe unter einer extremen Eigenspannung, bzw. werden je nach Zusammensetzung beim Flammspritzverfahren unter sehr hohe Eigenspannungen.
3. Auch werden Pulvermischungen eingesetzt, welche in Art und Weise eine nachträgliche DLC-Beschichtung im eigentlichen Sinne nicht zulassen, diese sogar abstoßen, wenn diese Kohlenstofffrei sein müssen bzw. sollen.

Aus dem Stand der Technik sind verschiedene Ansätze bekannt, mit deren Hilfe die Haftung einer DLC-Schicht auf einem Werkstoff und/oder Werkstück verbessert werden soll.

So ist z.B. ein Verfahren zur Verbesserung der Haftung einer DLC-Schicht auf. HSS (Hochleistungsschnellschnittstahl) bekannt, bei welchem der Stahl unter Zuhilfenahme von Stickstoff aufnitriert wird. Dies hat sich aber in der Praxis insbesondere unter dem Aspekt der Wärmeeinwirkung als schwierig herausgestellt.

Die Offenlegungsschrift DE10213661 beschreibt in den Absätzen 24, 29, 31, 54 und 55 Beschichtungsverfahren mit den Schritten Vorbehandeln des Werkstücks durch Sputtern, Aufbringen einer Haftschicht, und Aufbringen einer diamantartigen Kohlenstoffschicht durch Plasmabeschichtung. Beim Vorbehandeln des Werkstücks werden zwei verschiedene Gase in Form von gegenläufigen Rampen zugeführt.

### Offenbarung der Erfindung

Aufgabe der vorliegenden Erfindung ist es daher, eine gut haftende Beschichtung für Werkstücke und/oder Werkstoffe bereitzustellen, die diesen an der Oberfläche eine große Härte, eine hohe Zähigkeit, eine hohe Widerstandsfähigkeit gegen tribologische Belastungen, eine hohe Glätte und einen niedrigen Reibkoeffizient verleiht, und die überdies Widerstandsfähig gegen Punktbelastungen ist.

Weitere Aufgabe der vorliegenden Erfindung ist es, eine gut haftende Beschichtung für Werkstücke und/oder Werkstoffe bereitzustellen, die Widerstandsfähig gegen Punktbelastungen ist und gleichzeitig geeignete Oberflär-heneigenschaften bezüglich der Oberflächenspannung und Beständigkeit bezüglich Farben und Reinigungsmitteln wie Säuren und Laugen besitzt, elektrisch isolierende und wärmeleitende Eigenschaften hat, und/oder Biokompatibilität und antiallergische Eigenschaften besitzt.

Weitere Aufgabe der vorliegenden Erfindung ist es, eine gut haftende Beschichtung für Schneid-, Span-, Bohr-, Schmiede-, Fräs-, Schraub und Stanzwerkzeug bereitzustellen, die eine hohe Lebensdauer und/oder Standzeit aufweist.

Weitere Aufgabe der vorliegenden Erfindung ist es, eine gut haftende Lebensdauer und/oder Standzeit verlängernde Beschichtung bereitzustellen, die sich für Klingen mit einer großen Schärfe eignet.

Diese Aufgaben werden mit den Merkmalen des vorliegenden Anspruchs 1 gelöst. Die Unteransprüche geben bevorzugte Ausführungsformen an. Dabei ist zu beachten, dass die genannten Bereichsangaben durchweg einschließlich der jeweiligen Grenzwerte zu verstehen sind.

Demnach ist erfindungsgemäß ein Verfahren zum Aufbringen einer Beschichtung auf Werkstücke und/oder Werkstoffe vorgesehen, aufweisend die folgenden Schritte:
a.2) Vorbehandeln bzw. Aktivieren des Werkstücks und/oder des Werkstoffs durch Sputtern
b) Aufbringen einer Hautschicht; sowie
c) Aufbringen einer hochfesten Deckschicht durch Plasmabeschichtung,
wobei die Gaszufuhr mindestens zwei verschiedener Gasse in Schritt a.2) in Form von gegenläufigen Rampen erfolgt, und wobei in Schritt a.2) neben Ar mindestens eines der Gase verwendet wird, ausgewählt aus der Gruppe enthaltend H₂ und/oder O₂, wobei H₂ und/oder O₂ mithilfe der oben genannten gegenläufigen Rampen durch Ar verdrängt wird.

Das Werkstück oder der Werkstoff kann insbesondere aus Keramik, Eisen, Stahl, hochlegiertem Strahl, Nickel, Kobalt und deren Legierungen mit Chrom, Molybdän und Aluminium, Kupfer und Kupferlegierungen, Titan oder Legierungen, die die vorgenannten Materialien aufweisen, bestehen. Des weiteren kann das Werkstück oder der Werkstoffe aus Metallen und/oder metallischen Legierungen auf Basis von Zn, Sn, Cu, Fe, Ni, Co, Al, Ti, und den Refraktärmetallen wie Mo, W, Ta etc bestehen. Weiter kommen gesinterte Metallwerkstoffe und

Metall-Keramik-Komposite (MMC) und Metall-Polymer-Komposite sowie keramische Werkstoffe aus Oxiden, Karbiden, Boriden und Nitriden in Frage.

Ebenso kann das Werkstück auch aus Kunststoff oder einem Kunststoffgemisch bestehen. Natürlich kommen auch Mischungen Legierungen oder Verbünde der genanten Werkstoffe in Frage.

Wie bereits eingangs erwähnt, wird gemäß der vorliegenden Erfindung die hochfeste Deckschicht durch Plasmabeschichtung aufgebracht. Hierbei wird neben einem inerten Schutzgas bevorzugt ein kohlenstoff- oder siliziumhaltiges Reaktionsgas verwendet, so z.B. Methan (CH₄), Ethen (C₂H₄), Acetylen (C₂H₂), Methyl-Trichlor-Silan (CH₃SiCl₃) oder Tetramethyldisiloxan (C₄H₁₄OSi₂).

Auf diese Weise läßt sich z.B. eine kohlenstoffhaltige Deckschicht abscheiden, die häufig diamantähnliche Eigenschaften und Strukturen aufweist und deshalb auch als DLC-Schicht ("diamond like carbon") bezeichnet wird. Solche Schichten kommen als besonders bevorzugte Ausgestaltungen der Erfindung zum Einsatz.

Eine Siliciumnitrid-Schicht als Deckschicht wird hingegen unter Verwendung der Reaktionsgase Ammoniak und Dichlorsilan erzeugt. Für Siliciumdioxid-Schichten werden die Reaktionsgase Silan und Sauerstoff verwendet. Solche Schichten sind ebenfalls besonders bevorzugte Ausgestaltungen der Erfindung.

Zur Herstellung von Metall/Silicium-Hybriden (Siliciden) als Deckschicht wird als Reaktionsgas z.B. Wolframhexafluorid (WF₆) eingesetzt.

Titannitrid-Schichten als Deckschicht zum Härten von Werkzeugen werden aus TDMAT (Tetrakis-Dimethyl-Amido-Titanium) und Stickstoff erzeugt. Siliciumcarbid-Schichten werden aus einem Gemisch aus Wasserstoff und Methyl-Trichlor-Silan (CH₃SiCl₃) abgeschieden.

Grundsätzlich ist für ein Abscheiden aus der Gasphase erforderlich, dass das abzuscheidende Material in Gasform für das Verfahren verfügbar gemacht werden kann ("Reaktionsgas"). Hierzu kommen bei Raumtemperatur in Gasform vorliegende bzw. flüssige, leicht flüchtige Materialien in Frage. Aus der DE 10 2007 020 852 des Anmelders der vorliegenden Erfindung ist erstmals eine Vorrichtung bekannt, mittels welcher bei Raumtemperatur in fester Form vorliegende Materialien (wie z.B. TiO₂) für das Abscheiden aus der Gasphase verfügbar gemacht werden kann, um auf diese Weise Kohlenstoff- und/oder Siliziumoxide funktionell zu dotieren oder aber Reinbeschichtungen auf Basis der besagten Feststoffe zu erzeugen. Der Offenbarungsgehalt der DE 10 2007 020 852 soll als der vorliegenden Anmeldung vollumfänglich hinzugefügt gelten.

Besonders bevorzugt ist dabei die Abscheidung von titanhaltigen Schichten, wobei als Ausgangmaterial bevorzugt Titanisopropoxid (C₁₂H₂₈O₄Ti) zum Einsatz kommt.

Die erfindungsgemäße Haftschicht trägt auf verschiedenerlei Weise zu einer verbesserten Haftung der Deckschicht auf dem Werkstück bzw. Werkstoff bei. So
- gleicht sie Unebenheiten der Werkstoffoberfläche aus
- weist sie idealerweise eine intermediäre Eigenspannung auf, also eine Eigenspannung, die zwischen der des Werkstoffs und der des Materials der Decksicht liegt
- wird die Zwischenschicht mit der Eigenspannung verquer zur Eigenspannung des Materials, also des Substrates aufgebracht und hat dadurch eine ausgleichende Wirkung.

Häufig besteht das zu beschichtende Werkstück bzw. der zu beschichtende Werkstoff aus Metall, insbesondere aus Stahl oder Edelstahl, Aluminium oder Titan und deren Legierungen. Die Oberfläche dieser Metalle ist im Vergleich zu der aufgebrachten hochfesten kohlenstoff- oder siliziumhaltigen Deckschicht relativ weich und leicht plastisch verformbar. Im Gegensatz hierzu ist die genannte Deckschicht zwar überaus hart, aber dafür spröde. Dies führt in manchen Situationen, nämlich z.B. extrem hohen Punktbelastungen, dazu, dass sich des Werkstück bzw. der Werkstoff plastisch verformt und die Deckschicht aufgrund ihrer Sprödheit dieser Verformung nicht folgen kann, sondern bricht oder platzt. Man kann sich dieses Verhalten veranschaulichen am Bild einer dünnen Glasscheibe, die auf einer Matratze liegt, und die bei Punktbelastung bricht.

Werkzeuge und Werkstoffe, die mit einer solchen Deckschicht beschichtet sind, weisen also bei bestimmten Anwendungsbereichen und Belastungsszenarien geringe Lebensdauern und/oder Standzeiten auf. Aus diesem Grunde weist das Verfahren vor Schritt b) den Schritt
a.1) Aufbringen einer Stützschicht auf das Werkstück und/oder den Werkstoff
auf.

Diese Stützschichten weisen nicht die extreme Härte der Decksicht auf, haben aber ausreichend zähharte Eigenschaften, so dass sie bei hohen Punktbelastungen nicht nachgeben, und so einen Bruch oder ein Abplatzen der Deckschicht verhindern. Auf die Eigenschaften besagter Stützschicht wird weiter unten noch eingegangen.

In einer anderen bevorzugten Ausgestaltung des erfindungsgemäßen Verfahrens weist das Verfahren vor Schritt b) den Schritt
a.2) Vorbehandeln bzw. Aktivieren des Werkstücks und/oder des Werkstoffs durch Sputtern.
auf:

Es kann hier also vorgesehen sein, dass sowohl das Werkstück und/oder der Werkstoff selbst als auch die anschließend ggf. aufgebrachte Stützschicht durch Sputtern vorbehandelt bzw. aktiviert wird. Der Schritt a.2) kann also vor und/oder nach dem Schritt a. 1) durchgeführt werden.

Der Begriff "Sputtern" oder "Sputterätzen" bezeichnet einen physikalischen Vorgang, bei dem Atome aus einem Festkörper durch Beschuss mit energiereichen Ionen herausgelöst werden und in die Gasphase übergehen. Dies Ionen werden häufig - ähnlich wie beim PECVD - durch Erzeugung eines Plasmas mittels eines hochfrequenten elektromagnetischen Wechselfeldes in einer Vakuumkammer erzeugt. Als Reaktionsgas kommen hier in der Regel Edelgase in Frage, wie zum Beispiel Argon (Ar₂). Bei hochfestem Grundsubstrat (z.B. einer Flammspritzschicht auf Wolframcarbid-Basis) wird bevorzugt Sauerstoff (O₂), bei nicht eisenhaltigen Werkstoffen wie z.B. Messing, Bronze, Aluminium usw. eine Mischung aus Sauerstoff (O₂) und Wasserstoff (H₂).

Auch finden je nach Substrat eine Mischung aus H₂ und O₂ Verwendung, wenn die nachfolgende Zwischenschicht bzw. das zu beschichtende Substrat dieses erfordert. Durch das Ionenätzen wird die Substratoberfläche bis in den Nanobereich gereinigt und in nominalem Sinne abgetragen. Dieses Abtragen der Oberfläche ist z.B. unter Zuhilfenahme von O₂ nach kurzer Zeit messbar und bewegt sich pro Stunde im Bereich um 100 nm. Dadurch ist sichergestellt, dass die zu behandelnde Substratoberfläche frei von allen Verunreinigungen ist. Gerade bei der Verwendung von Bronze und Messing als zu beschichtendes Substrat ist der Einsatz zum Reinigen der Oberfläche, im weitesten Sinne sogar die Aktivierung, durch eine Mischung von H₂ und O₂ nötig um überhaupt eine Haftung zu erzielen.

Bevorzugt ist vorgesehen, dass besagte Stützschicht durch mindestens ein Verfahren ausgewählt aus der Gruppe
- Hochgeschwindigkeitsflammspritzen,
- Plasmaspritzen,
- Flammspritzen,
- Eloxieren, einschließlich Harteloxieren,
- Galvanisieren,
- Pulverbeschichten und/oder
- Elektrophorese
- Hartanodisation
aufgebracht wird.

Beim Hochgeschwindigkeitsflammspritzen (HVOF) wird das Spritzpulver mit sehr hoher Geschwindigkeit auf das zu beschichtende Substrat gespritzt. Die Wärme zum Aufschmelzen des Pulvers wird durch die Reaktion von Sauerstoff und Brenngas, z.B. vergastes Kerosin, in der Brennkammer erzeugt. Die Temperaturen, die in der Flamme erreicht werden, betragen bis zu etwa 3000°C. Durch die Reaktion dehnt sich das Gas aus und beschleunigt das Spritzpulver auf eine hohe Geschwindigkeit.

Beim Plasmaspritzen wird in der Regel ein Plasmabrenner verwendet, bei dem eine Anode und Kathode durch einen schmalen Spalt getrennt sind. Durch eine Gleichspannung wird ein Lichtbogen zwischen Anode und Katode erzeugt. Das durch den Plasmabrenner strömende Gas wird durch den Lichtbogen geleitet und hierbei ionisiert. Die Ionisation, bzw. anschließende Dissoziation, erzeugt ein hochaufgeheiztes (bis 20000 K), elektrisch leitendes Gas aus positiven Ionen und Elektronen. In diesem erzeugten Plasmajet wird Pulver eingedüst, das durch die hohe Plasmatemperatur aufgeschmolzen wird. Der Plasmagasstrom reißt die Pulverteilchen mit und schleudert sie mit einer Geschwindigkeit von bis zu 1000 m/s auf das zu beschichtende Werkstück. Die Gasmoleküle kehren bereits nach kürzester Zeit wieder in einen stabilen Zustand zurück, setzen keine Energie mehr frei und so sinkt die Plasmatemperatur bereits nach kurzer Wegstrecke wieder ab. Die Plasmabeschichtung erfolgt in der Regel unter atmosphärischem Druck. Für die Schichtqualität sind insbesondere die kinetische und die thermische Energie des Plasmas von Bedeutung. Verwendete Gase sind Argon, Helium, Wasserstoff, Sauerstoff oder Stickstoff.

Das Flammspritzen mit Pulver ist das älteste Verfahren der Thermischen Spritztechnik. Bedingt durch die Brenngas/Sauerstoff-Flamme als Wärmequelle können nur niedrig schmelzende Metalle und Legierungen verarbeitet werden. Durch Flammspritzen mit nachträglichem Einschmelzen von z.B. Nickel- oder Kobaltbasis-Hartlegierungen können dichte und dicke Schichten bis 2,5 mm erzielt werden. Beimengungen von Karbiden bewirken eine deutliche Härtesteigerung.

In allen drei Fällen liegt das Beschichtungsmaterial als Pulver vor. Bevorzugt sind hier metallgebundene Karbide, wie Wolframkarbid, Chromkarbid, Titankarbid, Siliziumkarbid, oder Oxide, wie Aluminiumoxid, Titandioxid, Chromoxid, Magnesiumoxid, Zirkonoxid und deren Legierungen und Mischungen.

Beim Flammspritzen mit Draht liegt der Beschichtungswerkstoff als Draht vor. Durch die Brenngas/Sauerstoff-Flamme und die Gasgeschwindigkeit wird der Schichtwerkstoff aufgetragen. Typische Beschichtungswerkstoffe bei diesem Verfahren sind Metalle, z.B. Molybdän, Cr-Stahl, Cr-Ni-Stahl, Zn, etc.

Das Eloxieren ("Eloxal-Verfahren") ist ein Verfahren, bei dem eine oxidische Schutzschicht auf ein Aluminium-Werkstück bzw. -Werkstoff, die durch anodische Oxidation aufgebracht wird. Dabei wird im Gegensatz zu den galvanischen Überzugsverfahren die Schutzschicht nicht auf dem Werkstück niedergeschlagen, sondern durch Umwandlung der obersten Metallzone ein Oxid bzw. Hydroxid gebildet. Es entsteht eine 5 bis 25 Mikrometer dünne Schicht, die das Aluminium vor Korrosion schützt. Die natürliche Oxidschicht des Aluminiums beträgt hingegen lediglich wenige Nanometer. Die Härte der Eloxal-Schicht liegt bei etwa 8-9 nach der Härteskala von Mohs, d. h. zwischen Quarz und Korund.

Als anodische Harteloxierung oder Hartanodisation (engl. Hardcoat) bezeichnet man die Oxidation von Aluminium-Oberflächen, welche in stark gekühlten Elektrolyten erzeugt wird. Diese Beschichtung zeichnet sich durch hohe Verschleiß-, Hitze-, Korrosions- und elektrische Widerstandsfähigkeit aus. Hinzu kommen gute Gleiteigenschaften bei stark reduzierten Massekräften. Da sich die Harteloxal-Schicht aus dem Grundmaterial selbst bildet, gibt es keine Adhäsionsprobleme. Die guten Verschleißeigenschaften sind zurückzuführen auf das sich während des Prozesses bildende Aluminiumoxid aus dem die Harteloxal-Schicht besteht. Angewandt wird die Hartanodisierung bei stranggepressten Profilen und Drehteilen sowie bei Druck-, Sand- und Kokillenguss, Schmiede- und Knetlegierungen. Dieser Begriff umfasst mehrere Anodisierungstechniken, mit denen sich bei niedriger Temperatur dicke (50 - 100 µm) und dichte Oxidschichten herstellen lassen. Diese sind abriebfester als die besten Vergütungsstähle und weisen ein elektrisches Isolationsvermögen in der Größenordnung von Porzellan auf. Hartanodisierte Produkte werden in Elektrik und Mechanik eingesetzt. Zur Verringerung des Reibbeiwertes eignen sich unterschiedliche Imprägnierungsstoffe wie z.B. Lanolin, Teflon, Molybdänsulfid usw. Angesichts der sehr hohen Schichtdicken kann es in bestimmten Fällen erforderlich werden, mit veränderten Abmessungen des Werkstücks nach dem Anodisieren zu rechnen.

Unter Galvanisiseren versteht man die elektrochemische Abscheidung von metallischen Niederschlägen auf Werkstücken bzw. Werkstoffen. Dabei wird durch ein elektrolytisches Bad Strom geschickt. An der Anode (Verbrauchselektrode) befindet sich das Metall, das aufgebracht werden soll (z. B. Kupfer, Nickel, Kobalt, Mangan, Chrom oder bestimmte Legierungen), an der Kathode das zu beschichtende Werkstück bzw. der Werkstoff. Der elektrische Strom löst dabei Metallionen von der Verbrauchselektrode ab und lagert sie durch Reduktion auf der Ware ab. So wird der zu veredelnde Gegenstand allseitig gleichmäßig mit Kupfer oder einem anderen Metall beschichtet. Je länger sich der Gegenstand im Bad befindet und je höher der elektrische Strom ist, desto stärker wird die Metallschicht (z. B. Kupferschicht). Die Oberflächenhärte des Werkstücks bzw. Werkstoffs kann auf diese Weise erhöht werden.

Das Pulverbeschichten ist ein Beschichtungsverfahren, bei dem ein in der Regel elektrisch leitfähiger Werkstoff bzw. ein Werkstück mit Pulverlacken beschichtet wird. Dabei wird das Pulver elektrostatisch oder tribostatisch auf den zu beschichtenden Untergrund aufgesprüht und anschließend eingebrannt. Im Vorfeld ist das Werkstück gut zu entfetten und gegebenenfalls mit Korrosionsschutz zu behandeln. Heutzutage können die Einbrenntemperaturen, je nach Anwendungsfall, stark variieren. Typische Einbrennbedingungen liegen zwischen 140 und 200 °C. Es werden heutzutage verschiedene Bindemittel eingesetzt, typisch sind jedoch Pulverlacke auf Basis von beispielsweise Polyurethan-, Epoxid- oder Polyesterharzen. Wegen des Einbrennens wird eine dauerhafte Anhaftung (rein mechanische Verklammerung) und eine gleichmäßige dichte Beschichtung erreicht, was teils durch Koagulation (quasi Versintern), teils durch Anschmelzen der Partikel erfolgt. Das Pulver kann auch durch Wirbelsintern aufgebracht werden. Dabei wird ein erhitztes Werkstück kurz in ein mit Hilfe von Druckluft fluidisiertes Pulver aus Kunststoff getaucht. Das Pulver verschmilzt an der Oberfläche zu einer Kunststoffschicht, da das Werkstück durch die Hitze das Pulver zum Schmelzen bringt.

Besonders bevorzugt können verschiedene der genannten Verfahren auch kombiniert werden. So ist z.B. eine Kombination aus elektrophoretischer und galvanischer Abscheidung in aufeinanderfolgenden Schritten. Beispielsweise kann zunächst eine Keramikschicht (z.B. yttriumstabilisiertes Zirkonoxid) elektrophoretisch auf einem Werkstück erzeugt und dann bei 1100 °C zu einer offenporösen Schicht versintert werden. Im nächsten Schritt wird dann durch Galvansieren z.B. Nickel in die Poren der Schicht abgeschieden. Durch eine finale thermische Behandlung wird die Anbindung der so hergestellten Komposit-Stützschicht an das Werkstück bzw. den Werkstoff verbessert.

Grundprinzip der Elektrophorese ist die Wanderung dispergierter Partikel in einem elektrischen Gleichfeld und deren Abscheidung an einer Elektrode. Dabei werden in der Regel keramische Pulver (wie z.B. Yttriumoxid Y₂O₃ und Titanoxid) dispergiert, beispielsweise in Ethanol, oder einem Wasser-Ethanol-Gemisch. Häufig werden wird ein Diespergiermittel verwendet, beispielsweise 4-Hydroxy-Benzoesäure, die gleichzeitig als Binder in der Grünschicht (= ungesinterte, bereits abgeschiedene Schicht) fungieren kann.

Die Beschichtung erfolgt in der Regel bei einer Gleichspannung von 5 - 200 V. Als Beschichtungssubstrat wird das zu beschichtende Werkstück bzw. der Werkstoff verwendet, der gleichzeitig als Elektrode fungiert. Die Gegenelektrode besteht z.B. aus Graphit.

Nach der elektrophoretischen Beschichtung erfolgt in der Regel eine mehrstündige Trocknung der Schicht an der Luft. Anschließend wird bei einer Temperatur zwischen 800 und 1500 °C gesintert. Auf diese Weise hergestellte Stützschichten können nach der Versinterung eine sehr hohe Porosität von bis zu 50 % aufweisen

Ebenso ist bevorzugt vorgesehen, dass es sich bei besagter Stützschicht um mindestens eine Schicht ausgewählt aus der Gruppe
- Eloxal-Schicht,
- Keramikschicht,
- Chrom(VI)-Schicht, und/oder
- Korund-Schicht,
handelt.

Bei einer Eloxalschicht handelt es sich um eine mit dem bereits erwähnten Eloxierverfahren aufgebrachte Schicht. Keramikschichten können mit verschiedenen der genannten Verfahren aufgebracht werden, insbesondere mit den genannten Spritzverfahren und den elektrophoretischen Verfahren. Eine Chrom (VI)-Schicht wird in der Regel durch Galvanisieren aufgebracht. Korundschichten bestehen aus Al₂O₃ und gelten mit einer Mohshärte von 9 nach dem Diamant als das zweithärteste Mineral. Korund gilt als technische Keramik und wird ebenso z.B. mit den genannten Spritzverfahren und den elektrophoretischen Verfahren als Beschichtung auf ein Werkstück bzw. einen Werkstoff aufgetragen.

Besonders bevorzugt ist vorgesehen, dass die Haftschicht mittels Plasmabeschichtung auf das Werkstück und/oder den Werkstoff aufgebracht wird.

Die besagte Haftschicht weist vorzugsweise Elemente aus der 6. und/oder 7. Nebengruppe auf. Bevorzugt werden hier Verbindungen verwendet, die die Elemente Cr, Mo, W, Mn, Mg, Ti und oder Si, und insbesondere Gemische derselben, enthalten. Ebenso können sich die einzelnen Bestandteile gradiert über die Tiefe der Haftschicht verteilen. Insbesondere bevorzugt ist hierbei Si. Als Reaktionsgas kommt hier z.B. das unter Vakuumbedingungen leicht flüchtige TMS in Frage.

In einer besonders bevorzugten Ausgestaltung ist vorgesehen, dass das in Schritt a.2) mehrere Gase verwendet werden. Schritt a.2) stellt in dieser Ausgestaltung also ein Mehrgas-Sputterverfahren dar, auf dessen Vorteile noch eingegangen wird.

Besonders bevorzugt ist vorgesehen, dass Schritt b) und/oder Schritt c) unter einer inerten und/oder einer reduzierenden Atmosphäre durchgeführt wird.

Die Bereitstellung einer inerten und/oder einer reduzierenden Atmosphäre hat verschiedene Aufgaben. So soll
- verhindert werden, dass die Oberfläche eines metallischen Werkstücks und/oder Werkstoffs oxidiert und damit passiviert wird, was die spätere Haftung der haft- und/oder der Deckschicht beeinträchtigen kann;
- verhindert werden, dass bei der Abscheidung von Kohlenstoff CO und/oder CO₂ entstehen, was zur Ausbildung von Lunkern, Gasblasen und Mikrokavitäten in der
kohlenstoffhaltigen Schicht führen und so eine raue, weniger dichte und weniger belastbare Oberfläche schaffen sowie die Haftung der Deckschicht erheblich beeinträchtigen würde;

Die Bereitstellung einer inerten und/oder einer reduzierenden Atmosphäre kann auf verschiedenerlei Weise erfolgen. So kann einerseits die Abscheidung in den Schritten b) und/oder c) unter einer Schutzgasatmosphäre erfolgen, beispielsweise durch zeitgleiche Einspeisung von Ar.

Ebenso kann vorgesehen sein, dass vor der Einleitung der Schritte b) und/oder c) die Kammer mit einem Schutzgas wie z.B. Ar gespült wird, um ggf. vorhandene Restbestände eines oxidierenden Gases wie z.B. O₂ aus der Kammer zu verdrängen und/oder als Überleitung einen Spülgang mit Stickstoff einzuleiten

Erfindungsgemäß ist ferner vorgesehen, dass die Gaszufuhr mindestens zwei verschiedener Gase
- in Schritt a.2), und/oder
- beim Übergang von Schritt b) nach Schritt c)
in Form von gegenläufigen Rampen erfolgt. Der Begriff" in Form von gegenläufigen Rampen" soll im Zusammenhang mit der vorliegenden Erfindung bedeuten, dass während des Sputterns bzw, des PECVD-Verfahrens das Minutenvolumen mindestens eines Reaktionsgases gestuft oder stufenlos reduziert wird, während das Minutenvolumen eines anderen Gases gestuft oder stufenlos erhöht wird.

Diese Rampen sind vorliegend erstmals beschrieben. Gemäß der Erfindung haben diese Rampen in Schritt a.2) (Sputtern) einerseits und beim Übergang von Schritt b) nach Schritt c) (PECVD) andererseits unterschiedliche Funktionen.

Beim Sputtern haben sie den Effekt, dass ein Reaktionsgas sukzessive durch ein anderes Reaktionsgas verdrängt wird, was für anschließende Prozessschritte, in denen z.B. das zuerst verwendete Reaktionsgas stört, sinnvoll sein kann.

Beim PECVD haben die Rampen den Effekt, dass die Abscheidungsphasen zweier Materialien ineinander übergehen. Auf diese Weise werden Übergangsbereich mit graduell sich ändernden Anteilen der verschiedenen Beschichtungsmaterialien geschaffen. Dies führt zu einer engeren Verzahnung der beiden Schichten miteinander und somit z.B. zu einer besseren Haftung der Deckschicht an der Haftschicht.

Zentrales Wesen der besagten Rampen ist, das zeitlich koordiniert ein gradueller Übergang von mindestens einem Reaktionsgas zu mindestens einem anderen Reaktionsgas erfolgtem Beschichtungsgas für die Zwischenschicht zum Beschichtungsgas für die Deckschicht muss fließend mit einem bestimmten zeitlichen Gradienten eingestellt werden. Dasselbe gilt ggf. für die Veränderung der Biaszahl sowie ggf. für weitere Beschichtungsparameter. So muß sichergestellt sein, das vor jedem Übergang der Reaktionsgase die Kammer auf dem gewollten Biaswert hoch- oder herabgefahren ist, um wiederum die Ausbildung einer Eigenspannung zu vermindern. So muß die sprunghafte Einstellung des Biaswertes mindestens 5 Sekunden vor der Beginn der Einstellung des Gradienten, längstens aber 15 Sekunden vor demselben, erfolgen.

Auch hat sich als vorteilhaft herausgestellt, dass während des gesamten Beschichtungsprozess der Deckschicht "Dauergradienten" gefahren werden, um spannungsarme Deckschichten zu erhalten. Dies bedeutet in der Praxis, dass während des gesamten Beschichtungsprozesses der Deckschicht das Minutenvolumen der Gaszufuhr niemals konstant bleibt, sondern periodisch variiert, die Biasspannung jedoch konstant gehalten wird. Auf diese Weise kann z.B. eine DLC- Deckschicht mit einer Dicke von bis zu 10µ spannungsarm aufgebracht werden.

Der Übergang von Schritt b) nach Schritt c) kann z.B. so gestaltet sein, dass zunächst eine siliziumhaltige Haftschicht durch Plasmabeschichtung aufgebracht wird. Hierzu wird beispielsweise das bei Raumtemperatur flüssige, jedoch unter hypobaren Bedingungen leicht flüchtige Tetramethyldisiloxan (C₄H₁₄OSi₂) verwendet. Nach einer gewissen Zeit wird das Gasminutenvloumen für TMS sukzessive reduziert und das Gasminutenvolumen für das Kolhenstoffhaltige Gas Acetylen (Ethen) sukzessive erhöht.

Besagte Rampe könnte wie folgt aussehen: Nach einem optionalen Sputterschritt (a.2) wird 5 s vor Beginn der Auftragung der Zwischenschicht die Biasspannung V_{Bias} auf für die Beschichtung erforderliche Höhe angehoben. Danach wird mit einer extrem kurze Rampe (10 s) das silanhaltige, verdampfte Gas TMS eingelassen. Nach Ablauf der Abscheidungszeit für die Haftschicht wird das Acetylen-Ventil über einen Zeitraum von 500 s auf den gewünschten Einlasswert graduell geöffnet. Gleichzeitig schließt sich das Ventil für TMS in gleicher Zeit graduell. Anschließend wird die Deckschicht noch über die gewünschte Zeit aufgetragen. Tabelle 1 gibt dieses Verfahren mit beispielhaften Werten wieder:

**Tabelle 1**

| **Zeit (s)** | **Schritt** | **V_{bias}** | **TMS (sccm)** | **C₂H₂ (sccm)** |
|---|---|---|---|---|
| 0 | Haftschicht (b) | 350 | 300 | 0 |
| 600 | Rampe | 350 | 300 | 0 |
| 1100 | Deckschicht (c) | 350 | 0 | 250 |
| 2000 bis X | Deckschicht (c) | 350 | 0 | 250 |

Die Aufbringung der Deckschicht kann im Prinzip beliebig lange dauern. Dabei wächst die Dicke der Deckschicht proportional mit der Beschichtungsdauer. Aus diesem Grunde wurde in obiger Tabelle als Zeitwert die Variable "X" gewählt.

In Abweichung der in Tabelle 1 gezeigten Werte werden bei den verschiedenen Schritten im wesentlichen folgende Parameterbereiche bevorzugt:

**Tabelle 2**

| **Schritt** | **V_{bias}** | **TMS (sccm)** | **C₂H₂ (sccm)** | **Druck/ Temp** |
|---|---|---|---|---|
| Haftschicht (b) | 200-500 | 100-500 | 0 | 0,1-2 P |
| | | | | 50-150°C |
| Deckschicht (c) | 250-600 | 20-150 | 100-500 | 0,01-0,9 P |
| | | | | 50-150°C |

Ebenso kann überdies vorgesehen sein, dass in Bezug auf die für die Haftschicht verwendeten Materialien Rampen gefahren werden. So kann während der Auftragung vorgesehen sein, dass ein Material Sukzessive durch ein anderes ersetzt wird.

Beim Aufbringen der Deckschicht in der Plasmabeschichtungskammer werden überdies bevorzugt folgende Verfahrensparameter eingehalten:

**Tabelle 3**

| | |
|---|---|
| Temperatur: | 50 - 150 °C, bevorzugt 80 °C |
| Kammervo lumen: | 200 - 10.000 1, bevorzugt 900 1 |
| Kammerdruck: | 0.0 - 3.0 Pa, |
| | bevorzugt 0.0 - 2.0 Pa |
| Biasspannung: | 200 Volt - 600 Volt |
| Dauer: | 1 - 100 Min. |
| Gasstrom: | 50 sccm - 700 sccm |

Die Gaskonzentration in der Kammer ergibt sich jeweils aus dem Gasfluss, dem Volumen der Kammer sowie dem darin herrschenden Druck. Für eine Kammer mit 900 1 Volumen und einem darin herrschenden Druck von 0,0-2,0 Pa ergibt sich z.B. für Acetylen (C₂H₂) bei einem Gasfluss von 100 sccm (0,1175 g per Minute) eine Konzentration von 0,011% des Kammervolumens. Weitere bevorzugt einzustellende Gasflüsse sind z.B. 200 sccm (0,2350 g per Minute C₂H₂ = 0,022 %), 300 sccm (0,3525 g per Minute C₂H₂ (0,033 %), 400 sccm (0,4700 g per Minute C₂H₂ = 0,044 %) und 500 sccm (0,5875 g per Minute C₂H₂ = 0,055%).

Eine auf diese Weise unter Verwendung von Acetylen als Reaktionsgas hergestellte DLC-Schicht weist eine Härte von 6000 - 8000 HV und eine Dicke von 0,90 µm bis 5,0 µm auf.

Im Prinzip stellt O₂ ein attraktives Reaktionsgas für das Sputtern dar, da die ionisierten Sauerstoffatome aufgrund ihres hohen Molekulargewichts eine hohe kinetische Energie aufweisen und daher eine Oberfläche effektiv reinigen könnten. Zudem ist Sauerstoff sehr billig.

Im Stand der Technik wird für das Sputtern eines metallischen Werkstoffs oder Werkstücks als Vorbehandlung bzw. Aktivierung für eine späterer Weiterbehandlung in der Regel jedoch kein O₂ verwendet, da dies oxidierend auf die metallische Oberfläche wirkt, dort eine mehr oder minder dicke Metalloxid-Schicht bildet und so die Oberfläche passiviert. Der Fachmann setzt daher für das vorbereitende Sputtern von eines metallischen Werkstoffs oder Werkstücks bevorzugt nicht reaktive Edelgase wie z.B. Argon ein, die jedoch sehr viel teurer sind als Sauerstoff. Ideal wäre en reduzierend wirkendes Gas wie z.B. H₂, da dies eine Passivierung der Metalloberfläche ebenfalls verhindern bzw. sogar rückgängig machen könnte Aufgrund seines geringen Molekulargewichts und damit verbundender geringer kinetischer Energien ist H₂ jedoch für das Sputtern nicht geeignet.

O₂ kommt allenfalls für das Sputtern von Kunststoffoberflächen in Frage, da hier eine Passivierung der Oberfläche durch Oxidation nicht zu befürchten ist.

Ein weiterer Grund für die Nichtverwendung von O₂ beim Sputtern besteht für den Fachmann dann, wenn anschließend an das Sputtern eine kohlenstoffhaltige Schicht per Plasmabeschichtung auf das Werkstück und/oder den Werkstoff aufgebracht werden soll. Eventuell vorhandene Restbestände an O₂ würden Kohlenstoff zu CO und/oder CO2 oxidieren, was zur Ausbildung von Lunkern, Gasblasen und Mikrokavitäten in der kohlenstoffhaltigen Schicht führen und so eine raue, weniger dichte und weniger belastbare Oberfläche schaffen sowie die Haftung der Deckschicht erheblich beeinträchtigen würde.

Ar2 weist jedoch aufgrund seines sehr hohen Molekulargewichts auch Nachteile auf, da es beim Sputtern zu einer sehr rauen Oberfläche führt, auf welcher sich nur scher schlecht eine Deckschicht wie z.B. eine DLC-Schicht aufbringen läßt.

Trotz der geschilderten Vorbehalte gegenüber O₂ als Reaktionsgas haben sich die Anmelder der vorliegenden Erfindung in einer bevorzugten Ausgestaltung des erfindungsgemäßen Verfahrens die Vorteile von O₂ zunutze gemacht. Die genannten Nachteile werden in einer bevorzugten Ausgestaltungen der Erfindung vermieden, in dem

Besonders bevorzugt enthält das Reaktionsgas in Schritt a.2) zumindest zeitweise die Gase H₂ und O₂. Dabei sorgt das im Reaktionsgas enthaltene H₂ dafür, dass die oxidierende Wirkung des O₂ reduziert wird und eine Passivierung der Metalloberflächen nicht eintritt. Unter diesen Voraussetzungen ist das Molekulargewicht des O₂ ideal, um eine effektive Reinigungswirkung beim Sputtern herbeizuführen, ohne jedoch die Oberfläche des Werkstücks und/oder Werkstoffs aufzurauhen..

Besagtes Verfahren kann wie folgt aussehen: Ein Werkstück wird mit H₂ und O₂ in einem stöchiometrischen Verhältnis von 1:2 bis 1:8 gesputtert. Die Anwesenheit von H₂ verhindert in oben geschilderter Weise die Passivierung der Werkstückoberfläche. Zum Zeitpunkt von T = 400s wird über eine Rampe das Minutenvolumen von H₂ sukzessive reduziert und stattdessen Ar₂ in die Kammer eingespeist. Zum Zeitpunkt von T = 600 s wird dann das Minutenvolumen von O₂ sukzessive reduziert, während das von Ar₂ konstant bleibt. Auf diese Weise wird verbleibender Sauerstoff in der Kammer restlos ausgewaschen/verdrängt.

Um während dieses Teilschritts die oben genannten nachteiligen Folgen des Sputterns mit Ar₂ zu reduzieren, kann das elektromagnetische Wechselfeld in dieser zeit heruntergefahren werden. Als Alternative hierzu kann versucht werden, die Dauer dieses Waschschritts möglichst kurz zu halten.

Anschließend wird die Ar-Zufuhr schlagartig gestoppt, TMS in die Kammer eingelassen und das Plasma ggf. erneut gezündet. In dieser Phase wird nun eine Silizium-Haftschicht auf der durch das Sputtern aktivierten Oberfläche aufgetragen. Zum Zeitpunkt von T = 1600 s wird über eine weitere Rampe das Minutenvolumen von TMS sukzessive reduziert und stattdessen C₂H₂ in die Kammer eingespeist, was zu einem Abscheiden von DLC führt. In der Übergangszeit werden also Silizium und Kohlenstoff zeitgleich abgeschieden, wobei der Siliziumanteil sukzessive reduziert und der Kohlenstoffanteil sukzessive erhöht wird. Auf diese weise wird ein Übergangsbereich zwischen Haft- und hochfester Deckschicht geschaffen, der die Haftung letzterer auf ersterer erheblich verbessert. Anschließend wird die Deckschicht noch über die gewünschte Zeit aufgetragen. Tabelle 4 gibt dieses Verfahren mit beispielhaften Werten wieder:

**Tabelle 4**

| **Zeit (s)** | **Schritt** | **V_{bias}** | **H₂/O₂ (sccm)** | **Ar (sccm)** | **TMS (sccm)** | **C₂H₂ (sccm)** |
|---|---|---|---|---|---|---|
| 0 | Sputter (a.2) | 300 | 50/150 | 0 | 0 | 0 |
| 400 | Rampe 1 | 300 | 50/150 | 0 | 0 | 0 |
| 600 | Sputter (a.2) | 300 | 0/150 | 200 | 0 | 0 |
| 1000 | Rampe 2 | 300 | 0/0 | 200 | 0 | 0 |
| 1200 | Pause | 300 | 0/0 | 0 | 0 | 0 |
| 1205 | Haftschicht (b) | 350 | 0 | 50 | 300 | 0 |
| 1600 | Rampe | 350 | 0 | 0 | 300 | 0 |
| 2200 | Deckschicht (c) | 350 | 0 | 0 | 0 | 250 |
| x | Deckschicht (c) | 350 | 0 | 0 | 0 | 250 |

Die Aufbringung der Deckschicht kann im Prinzip beliebig lange dauern. Dabei wächst die Dicke der Deckschicht proportional mit der Beschichtungsdauer. Aus diesem Grunde wurde in obiger Tabelle als Zeitwert die Variable "X" gewählt.

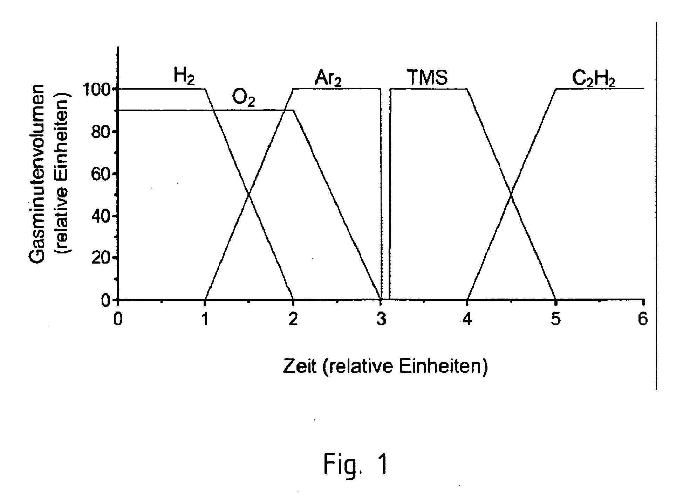

Die beispielhaft dargestellten Rampen sind in Fig. 1 als Diagramm gezeigt. In Abweichung der in Tabelle 1 gezeigten Werte werden bei den verschiedenen Schritten im Wesentlichen folgende Parameterbereiche bevorzugt:

**Tabelle 5**

| **Schritt** | **V_{bias}** | **H₂/O₂ (sccm)** | **Ar (sccm)** | **TMS (sccm)** | **C₂H₂ (sccm)** | **Druck/ Temp** |
|---|---|---|---|---|---|---|
| Sputter (a) | 300 - 600 | 0 - 200/ 0-200 | 0-200 | 0 | 0 | 0,5 - 2 Pa |
| | | | | | | 50- 50°C |
| Haftschicht (b) | 200 - 500 | 0 | | 100-500 | 0 | 0,1-2 Pa |
| | | | | | | 50-150°C |
| Deckschicht (c) | 250 - 600 | 0 | | 0-90 | 100-500 | 0,01-0,9 Pa |
| | | | | | | 50-130°C |

Während des gesamten Verfahrens werden bevorzugt folgende Verfahrensparameter eingehalten:

**Tabelle 6**

| | |
|---|---|
| Temperatur: | 50 - 50 °C, bevorzugt 80 °C |
| Kammervolumen: | 200 - 10.000 1, bevorzugt 9001 |
| Kammerdruck: | 0.0 - 3.0 Pa, bevorzugt 0.0 - 2.0 Pa |
| Biasspannung: | 200 Volt - 600 Volt |
| Dauer: | 1 - 100 Min. |
| Gasstrom: | 50 sccm - 700 sccm |

Die genannten Nachteile der Verwendung von O₂ werden erfindungsgenäß vermieden, in dem in Schritt a.2) H₂ und/oder O₂ mithilfe der oben genannten gegenläufigen Rampen durch Ar verdrängt wird.

Die Verdrängung mit Hilfe der gegenläufigen Rampen sorgt für eine besonders gründliche Auswaschung von O₂. Auf diese Weise wird O₂ gründlich aus der Beschichtungskammer entfernt, bevor die spätere Weiterbehandlung erfolgt, die - bei Anwesenheit von Restbeständen an O₂ - zu den genannten Beeinträchtigungen führen könnte.

Vor oder nach den Sputterschritt (a.2) - oder sogar anstelle des Sputterschritts (a.2) - kann ein Schritt (a.1) zur Auftragung einer Stützschicht geschaltet sein. Dieser Schritt kann z.B. die die Anwendung eines Verfahrens ausgewählt aus der Gruppe
- Hochgeschwindigkeitsflammspritzen,
- Plasmaspritzen,
- Flammspritzen,
- Eloxieren, einschließlich Harteloxieren,
- Galvanisieren,
- Pulverbeschichten und/oder
- Elektrophorese
umfassen

In einer weiteren Ausgestaltung des erfindungsgemäßen Verfahrens ist vorgesehen, dass das Verfahren in einer Plasmabeschichtungskammer durchgeführt wird, aufweisend eine flächige Hochfrequenzelektrode zur Erzeugung eines elektromagnetischen Wechselfeldes, und einen außerhalb der Kammer angeordneten Frequenzgenerator, dadurch gekennzeichnet, dass die Hochfrequenzelektrode mindestens zwei Zuleitungen aufweist, über welche sie mit einer vom Frequenzgenerator erzeugten Wechselspannung versorgt wird.

Eine solche Plasmabeschichtungskammer ist erstmals in der WO 2008/006856 Anmelder der vorliegenden Erfindung beschrieben.

Auf diese Weise läßt sich in der Kammer ein Wechselfeld mit sehr hohen Feldstärken erzeugen. Ein auf diese Weise erzeugtes Wechselfeld weist eine ausreichend hohe Durchschlagtiefe auf sowie eine große Homogenität auf. Auf diese Weise wird in allen Bereichen der Kammer ein homogenes Plasma und damit eine homogene Abscheiderate erzielt, was sich in eine konstanten Schichtdicke und daraus resultierend in geringen Eigenspannungsdifferenzen innerhalb der so erzeugten Beschichtung äußert. Beide Faktoren verbessern weiterhin die Haftung der erfindungsgemäß aufzutragenden hochfesten Deckschicht.

Bevorzugt sind dabei drei oder mehr Zuleitungen vorgesehen, da sich auf diese Weise ein noch homogeneres Wechselfeld einstellen lässt.

Dabei ist bevorzugt vorgesehen, dass die einzelnen Zuleitungen zu der Hochfrequenzeicktrode separat eingeregelt werden, dergestalt, dass in der gesamten Kammer, ein homogenes Wechselfeld mit gleichmäßig hohen Feldstärken erzeugbar ist. Dieses Merkmal kommt der Beschichtungsgüte sehr zugute.

Dies kann z.B. über eine sogenannte Matchbox erfolgen, die zwischen einen Hochfrequenzgenerator und die Hochfrequenz-Elektrode geschaltet ist. Diese weist z.B. Trimmpotentiometer für die einzelnen Zuleitungen zu der Hochfrequenz-Elektrode auf, die separat eingeregelt werden. Dabei wird an allen Reglern die gleiche Biasspannung eingestellt, was auf identische Feldstärken und damit ein homogenes Wechselfeld schließen läßt.

Weiterhin ist erfindungsgemäß die Verwendung einer Plasmabeschichtungskammer vorgesehen, letztere aufweisend eine flächige Hochfrequenzelektrode zur Erzeugung eines elektromagnetischen Wechselfeldes, einen außerhalb der Kammer angeordneten Frequenzgenerator, sowie mindestens zwei Zuleitungen aufweist, über welche die Hochfrequenzelektrode mit einer vom Frequenzgenerator erzeugten Wechselspannung versorgt wird, zum Aufbringen einer Beschichtung auf Werkstücke und/oder Werkstoffe gemäß einem der vorherigen Verfahrensansprüche.

Gegenstand der vorliegenden Erfindung ist überdies eine Beschichtung auf Werkstücken und/oder Werkstoffen, aufweisend die folgenden Schichten:
a) eine Haftschicht sowie
b) eine hochfeste Deckschicht,
   wobei Haft- und Deckschicht einen graduierten Übergangsbereich aufweisen, bzw. eine Beschichtung auf Werkstücken und/oder Werkstoffen, herstellbar mit einem erfindungsgemäßen Verfahren.

Die stofflichen Eigenschaften dieser Beschichtung, ihrer Ausgangsmaterialien sowie die Verfahrenseigenschaften und -Parameter für ihre Herstellung sind im Zusammenhang mit den bereits diskutierten Verfahrensansprüchen offenbart und sollen auch in Bezug auf die Beschichtung als solches für offenbart gelten. Dies gilt insbesondere für den durch die genannten Rampen erzielbaren Übergang zwischen Haft- und hochfester Deckschicht.

Ferner ist erfindungsgemäß bevorzugt vorgesehen, dass besagte Beschichtung außerdem eine Stützschicht aufweist, die zwischen dem Werkstück und/oder Werkstoff und der Haftschicht angeordnet ist. Die Eigenschaften und Vorteile besagter Stützschicht sind weiter oben bereits vollumfänglich offenbart.

Weiterhin ist Gegenstand der vorliegenden Erfindung ein Instrument, Werkstück bzw. Werkstoff oder Bauteil, das bzw. der mit einem der vorgenannten Verfahren bzw. mit einer vorgenannten Beschichtung beschichtet ist.

Bei diesem Instrument kann es sich z.B. um ein chirurgisches Instrument handeln, wie z.B. ein Skalpell. Ebenso kann es sich bei diesem Instrument um ein Stanzwerkzeug handeln. Weiterhin kann es sich bei dem Instrument z.B. um ein Fleischerei- oder Schlachterei-Schneidwerkzeug handeln

Durch die erfindungsgemäße Beschichtung werden die Standzeiten der genannten Instrumente z.T. erheblich verlängert. So behalten erfindungsgemäß beschichtete Schneidwerkzeuge ihre Schärfe erheblich länger, und zwar auch dann, wenn sie unter widrigen Umständen verwendet werden. Dies gilt insbesondere für Fleischerei- oder Schlachterei-Schneidwerkzeuge, die einerseits weiches Material (Fett, Muskel, Haut, Bindegewebe) schneiden müssen, andererseits jedoch auch hartes Material wie z.B. Knochen und Gefrorenes.

Ein anderes Beispiel sind chirurgische Instrumente, die häufig sterilisiert werden müssen, was bei nicht erfindungsgemäß beschichteten Instrumenten nach kurzer Zeit aufgrund der Sterilisationsbedingungen (Hitze, Feuchtigkeit und Druck) zu starker Korrosion führt. Hierdurch wird einerseits die Eignung des Instruments als solches beeinträchtigt, und anderseits leidet insbesondere die Schärfe der verwendeten Klingen stark.

Weitere erfindungsgemäß zu beschichtende Bauteile sind z.B.:
- Abdichtungen und Bauteile von rotierenden Maschinen wie Pumpen, Gaskompressoren und Turbinen, insbesondere Abdichtungen zwischen rotierendem Bauteil und stehendem Gehäuse
- Bauteile, die Adhäsionsverschleiß und typischem Fretting und Pitting unterliegen.
- Pneumatik- und Hydraulikanlagen, insbesondere das Abdichtungssystem "Stange und Zylinder", die Dichtelemente und die Oberflächen von Stangen und Zylindern.
- Motoreneinheiten und Bauteile, insbesondere Kolben mit oder ohne Kolbenringe, Laufbuchse und Zylinderlaufbahn, Ventile und Nockenwellen, Kolben und Pleuel.
- Bauteile von Maschinen, die aggressiven chemischen Prozessen ausgesetzt sind und deren metallische Oberflächen und / oder metallische Substrate chemisch angegriffen und korrodiert werden.
- Bauteile, die hohe Anforderungen an die Biokompatibilität stellen; insbesondere Prothesen, Implantate, Schrauben, Platten, künstliche Gelenke, Stents, biomechanische und mikromechanische Bauteile.
- Operative Bestecke, die grundsätzlich antiallergen sein müssen, wie z.B. Skalpelle, Zangen, Endoskope, Schneidinstrumente, Klammern etc.
- Bauteile, die chemisch beständige Oberflächen gegenüber druckfähige Farben und Reinigungsmittel aufweisen müssen und deren Oberflächen definierte Antihaft- und Flüssigkeitsabweisende und/oder Flüssigkeitsanhaftende Eigenschaften zur definierten Farbdosierung benötigen, wie z.B. Walzen, Zylinder, und Abstreifer von Druckmaschinen.
- Bauteile in stromführenden Maschinen, Rechnern und Anlagen, die eine wärmeabführende aber elektrisch isolierende Oberflächenbeschichtung benötigen, wie z.B. magnetische Speichermedien und Isolierungen von sich bewegenden Stromzuführungen.
- Sich bewegende Medienführungen für Gas, Flüssigkeiten und Gas- oder flüssigkeitsfluidisierte Feststoffmedien.
- Ersatz von nicht mehr zulässigen Hartchromschichten, wie sie z.B. für Hydraulikkolben und -zylinder in "Landing Gears" von Flugzeugen zum Einsatz kommen

Weitere erfindungsgemäß zu beschichtende Werkstücke und/oder Werkstoffe umfassen Schneid-, Bohr- und Schraubwerkzeuge, Zerspanungswerkzeuge, Kugel- oder Wälzlager, Zahnräder, Ritzel, Antriebsketten, Ton- und Antriebseinheiten in magnetischen Aufzeichnungsgeräten, sowie chirurgische und zahnchirurgische Instrumente

Grundsätzlich lassen sich erfindungsgemäß insbesondere Paarungen in Maschinen und Anlagen mit Reibgleit-Verschleiß vorteilhaft beschichten, da diese hohen Drücken und/oder Temperaturen ausgesetzt sind.

### Definitionen

Der Begriff "Minutenvolumen" steht für deinen normierten Gaseinstrom in die Plasmabeschichtungskammer. Die hierfür verwendete Dimension "sccm" steht für Standardkubikzentimeter pro Minute und stellt einen normierten Volumenstrom dar. In der Vakuumpumpentechnik spricht man auch von der Gaslast. Unabhängig von Druck und Temperatur wird mit dieser Norm eine definierte strömende Gasmenge (Teilchenzahl) pro Zeiteinheit erfasst. Ein sccm entspricht einem Gasvolumenstrom von V = 1 cm³ = 1 ml pro Minute unter Normbedingungen (T = 20°C und p = 1013,25 hPa ).

### Zeichnungen und Beispiele

Die vorliegende Erfindung wird durch die im Folgenden gezeigten und diskutierten Figuren und Beispiele genauer erläutert. Dabei ist zu beachten, dass die Figuren und Beispiele nur beschreibenden Charakter haben und nicht dazu gedacht sind, die Erfindung in irgendeiner Form einzuschränken.

### Beispiel 1

Ein mit dem beschriebenen Verfahren beschichtetes Schlachtermesser (Schichtaufbau: DLC Deckschicht mit Zwischenschicht auf einer HVOF Beschichtung aus metallgebundenem Wolframkarbid des Typs WC-Co 83 17) wies im Vergleich zu einem herkömmlichen Schlachtermesser mit Kombinationsbeschichtung eine dreifache Standzeit auf.

### Beispiel 2

Ein mit dem beschriebenen Verfahren beschichtetes industrielles Schneidmesser für Kartoffeln wies im Vergleich zu einem herkömmlichen Schneidmesser mit Kombinationsbeschichtung eine achtfach verlängerte Standzeit auf.

### Beispiel 3

Ein mit dem beschriebenen Verfahren beschichtetes Stanzwerkzeug für die Herstellung von Elektrosteckverbindern für die Automobilindustrie wies im Vergleich zu einem herkömmlichen Stanzwerkzeug eine zweifach verlängerte Standzeit auf.

Fig. 1 zeigt ein Zeitdiagramm des Verlaufs der in Tabelle 4 beschriebenen Rampen. Dabei zeigt der erste Block den Sputterschritt (a.2), während der zweite Block den Schritt b) zur Auftragung der Haftschicht und die Rampenartige Verzahnung derselben mit der in Schritt c) aufgetragenen Deckschicht darstellt.

Vor oder nach dem Sputterschritt (a.2) - oder sogar anstelle des Sputterschritts (a.2) - kann Schritt (a.1) zur Auftragung einer Stützschicht geschaltet sein.

Dieser Schritt kann z.B. die Anwendung eines Verfahrens ausgewählt aus der Gruppe
- Hochgeschwindigkeitsflammspritzen,
- Plasmaspritzen,
- Flammspritzen,
- Eloxieren, Eloxieren, einschließlich Harteloxieren,
- Galvanisieren,
- Pulverbeschichten, und/oder
- Elektrophorese
umfassen

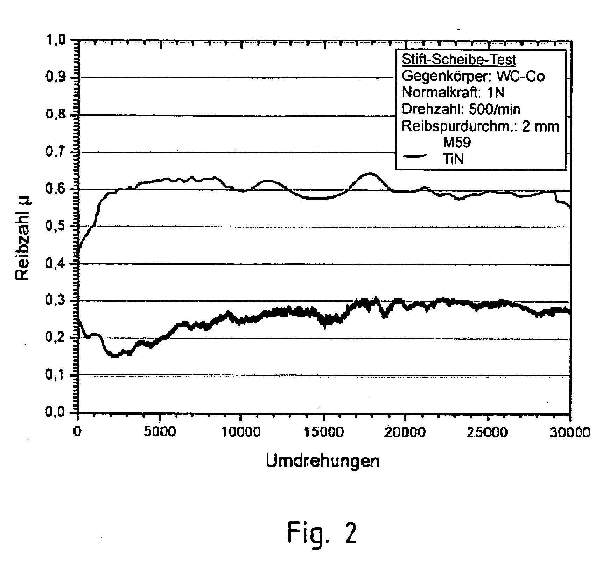

Die Figs. 2-4 zeigen die Ergebnisse der physikalischen Analyse von drei Edelstahl-Werkstücken, von denen eines mit einer Titannitrid-Beschichtung versehen ist ("TiN") sowie zwei weitere mit erfindungsgemäßen Beschichtungen ("M44", Schichtdicke 0,81 µm, "M59", Schichtdicke 0,84 µm, Schichtaufbau: DLC Deckschicht mit Haftschicht auf einer HVOF-Beschichtung aus metallgebundenem Wolframkarbid des Typs WC-Co 83 17). Titannitrid gilt im Stand der Technik als eine der härtesten und widerstandsfähigsten Beschichtungen für Schneid-, Fräs- und Stanzwerkzeuge.

Die Reibungs- und Verschleißprüfung wurde nach SOP 4CP1 (Stift-Scheibe-Tribologie) mit dem Messgerät: CSEM Tribometer Pin-Disc durchgeführt. Dabei wurden folgende Verfahrensparameter eingehalten:

### Beanspruchunqskollektiv:

- Gegenkörper: WC-Co-Kugel, Durchmesser 6 mm
- Schmierstoff: keiner
- Normalkraft FN: 1 N
- Drehzahl: 500 U/min
- Gleitgeschwindigkeit v: 52,4 mm/s
- Reibspurdurchmesser D: 2 mm

### Randbedingungen:

Umgebungstemperatur: 23°C +/- 1K
rel. Luftfeuchtigkeit: 50% +/- 6%

Fig. 2 zeigt die Ergebnisse der Ermittlung der Reibzahl .. Es ist klar erkennbar, dass die erfindungsgemäße Beschichtung mit einer mittleren Reibzahl µ von etwa 0.3 wesentliche Vorteile gegenüber der TiN-Beschichtung aufweist, deren mittlere Reibzahl fast durchweg doppelt so hoch ist.

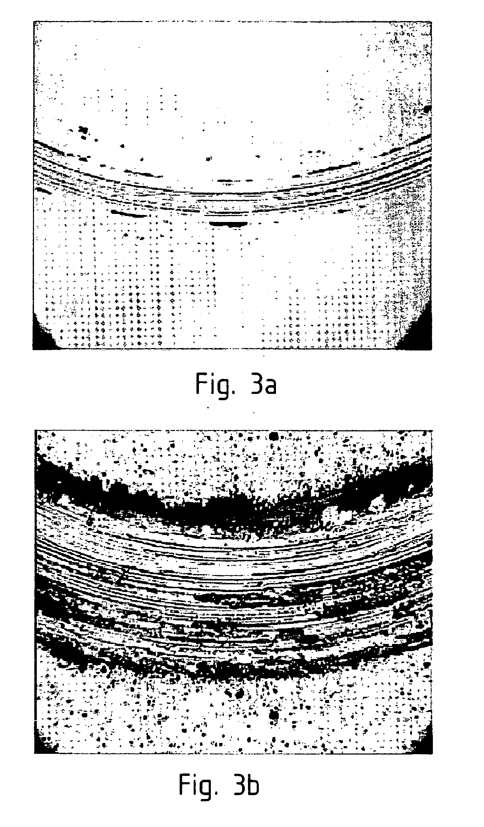

Fig. 3 zeigt die Lichtmikroskopische Dokumentation (Vergrößerung: 100 x) des Verschleißes in der Reibspur nach 30000 Umdrehungen bei der erfindungsgemäßen Beschichtung M59 (Fig. 3a) sowie der TiN-Beschichtung (Fig. 3b). Es ist hier klar erkennbar, dass die erfindungsgemäße Beschichtung einen wesentlich geringeren Verschleiß zeigt als die TiN-Beschichtung.

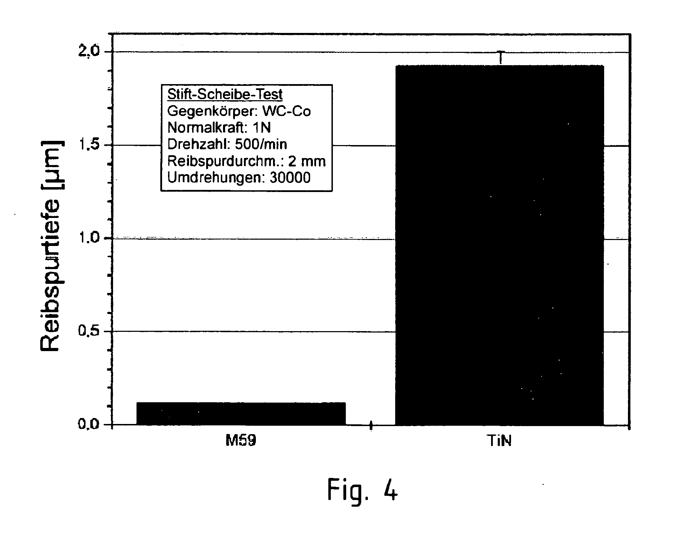

Fig. 4 zeigt die Ergebnisse der Profilometrischen Auswertung der Reibspurtiefe nach 30000 Umdrehungen. Auch hier ist klar erkennbar, dass die erfindungsgemäße Beschichtung einen wesentlich geringeren Verschleiß zeigt als die TiN-Beschichtung.

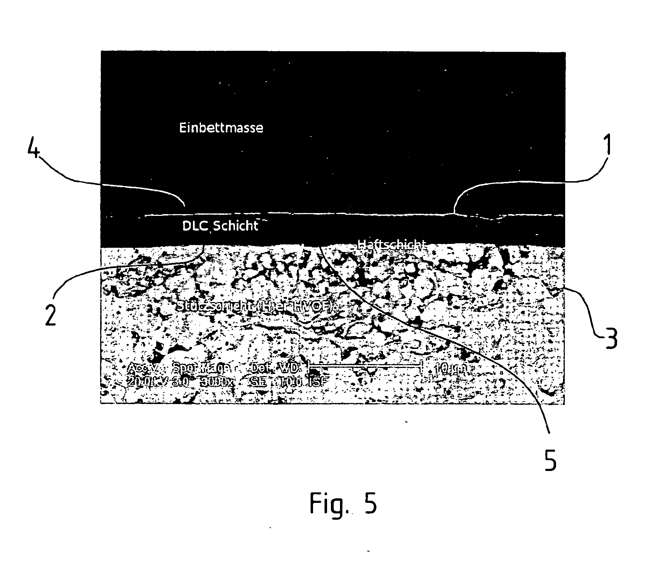

Fig. 5 zeigt eine elektronenmikroskopische Aufnahme eines Schnitts eines erfindungsgemäß beschichteten Werkstücks bei 3000-facher Vergrößerung. Gut zu erkennen sind die DLC-Schicht 1, die sich als helle Linie abzeichnende Haftschicht 2 und die Stützschicht 3 (hier eine HVOF-Stützschicht). Die DLC-Schicht hat eine Stärke von etwa 4 µm. Gut zu erkennen ist ferner, dass das Einbettungsmedium an der DLC-Schicht nur schlecht haftet; so hat sich die DLC-Schicht beim Schneiden vom Einbettungsmedium abgelöst (Spalt 4). Ferner ist zu erkennen, dass die per Plasmabeschichtungsverfahren aufgetragene DLC-Schicht imstande ist, Unebenheiten (5) der zuvor aufgetragenen Stützschicht auszugleichen.

## Patentansprüche

1. Verfahren zum Aufbringen einer Beschichtung auf Werkstücke und/oder Werkstoffe, aufweisend die folgenden Schritte:
a.2) Vorbehandeln bzw. Aktivieren des Werkstücks und/oder des Werkstoffs durch Sputtern
b) Aufbringen einer Haftschicht; sowie
c) Aufbringen einer hochfesten Deckschicht durch Plasmabeschichtung,
wobei
die Gaszufuhr mindestens zwei verschiedener Gase in Schritt a.2) in Form von gegenläufigen Rampen erfolgt, und wobei
in Schritt a.2) neben Ar mindestens eines der Gase verwendet wird, ausgewählt aus der Gruppe enthaltend H₂ und/oder O₂,
wobei H₂ und/oder O₂ mithilfe der oben genannten gegenläufigen Rampen durch Ar verdrängt wird.

2. Verfahren gemäß Anspruches 1, aufweisend vor Schritt b) den Schritt
a.1) Aufbringen einer Stützschicht auf das Werkstück und/oder den Werkstoff

3. Verfahren gemäß Anspruch 2, aufweisend vor Schritt b) mindestens einen Schritt der Vorbehandlung bzw. Aktivierung der Stützschicht durch Sputtern.

4. Verfahren gemäß einem der vorhergehenden Ansprüche 2 oder 3, **dadurch gekennzeichnet, dass** besagte Stützschicht durch mindestens ein Verfahren ausgewählt aus der Gruppe
• Hochgeschwindiglceitsflammspritzen,
• Plasmaspritzen,
• Flammspritzen,
• Eloxieren, einschließlich Harteloxieren,
• Galvanisieren,
• Pulverbeschichten, und/oder
• Elektrophorese
aufgebracht wird.

5. Verfahren gemäß einem der vorhergehenden Ansprüche 2 bis 4, **dadurch gekennzeichnet, dass** es sich bei besagter Stützschicht um mindestens eine Schicht ausgewählt aus der Gruppe
• Eloxal-Schicht,
• Keramikschicht,
• Chrom(VI)-Schicht, und/oder
• Korund-Schicht
handelt

6. Verfahren gemäß einem der vorhergehenden Ansprüche, **dadurch gekennzeichnet, dass** die Haftschicht mittels Plasmabeschichtung auf das Werkstück und/oder den Werkstoff aufgebracht wird.

7. Verfahren gemäß einem der vorhergehenden Ansprüche, **dadurch gekennzeichnet, dass** die Haftschicht Elemente aus der 6. und 7. Nebengruppe aufweist.

8. Verfahren gemäß einem der vorhergehenden Ansprüche, **dadurch gekennzeichnet, dass** Schritt b) und/oder Schritt c) unter einer inerten und/oder einer reduzierenden Atmosphäre durchgeführt wird.

9. Verfahren gemäß einem der vorhergehenden Ansprüche, **dadurch gekennzeichnet, dass** die Gaszufuhr mindestens zwei verschiedener Gase beim Übergang von Schritt b) nach Schritt c) in Form von gegenläufigen Rampen erfolgt.

10. Verfahren gemäß einem der vorhergehenden Ansprüche, **dadurch gekennzeichnet, dass** das Reaktionsgas in Schritt a.2) zumindest zeitweise die Gase H₂ und O₂ enthält.

11. Verfahren gemäß einem der vorhergehenden Ansprüche, wobei das Verfahren in einer Plasmabeschichtungskammer durchgeführt wird, aufweisend eine flächige Hochfrequenzelektrade zur Erzeugung eines elektromagnetischen Wechselfeldes, und einen außerhalb der Kammer angeordneten Frequenzgenerator, **dadurch gekennzeichnet, dass** die Hochfrequenzelektrade mindestens zwei Zuleitungen aufweist, über welche sie mit einer vom Frequenzgenerator erzeugten Wechselspannung versorgt wird.

12. Verwendung einer Plasmabeschichtungskammer aufweisend eine flächige Hochfrequenzelektrode zur Erzeugung eines elektromagnetischen Wechselfeldes, einen außerhalb der Kammer angeordneten Frequenzgenerator, sowie mindestens zwei Zuleitungen, über welche die Hochfrequenzelektrode mit einer vom Frequenzgenerator erzeugten Wechselspannung versorgt wird, zum Aufbringen einer Beschichtung auf Werkstücke und/oder Werkstoffe gemäß einem der vorherigen Verfahrensansprüche.

## Claims

1. A method for applying a coating to a workpiece and/or material, comprising the following steps:
a.2) Pre-treatment or activation of the workpiece and/or the material by sputtering
b) Application of an adhesive layer, and
c) Application of a high-strength top layer by plasma-coating,
wherein
at least two different gases are supplied in the form of opposing ramps in step a.2) and wherein
at least another gas besides Ar is selected in step a.2) from the group containing H₂ and/or O₂, wherein
H₂ and/or O₂ is/are replaced by Ar by means of the above mentioned opposing ramps.

2. The method according to claim 1, comprising before step b) the coating step a.1), wherein a supporting layer is deposited on the workpiece and/or material.

3. The method according to claim 2, comprising at least one pre-treatment or activation step of the supporting layer by sputtering before step b).

4. The method according to any of the preceding claims 2 or 3, **characterized in that** said supporting layer is applied using at least one method selected from the group consisting of
• High velocity flame-spraying,
• Plasma spraying,
• Flame spraying,
• Anodizing, including hard anodizing,
• Galvanization,
• Powder coating, and/or
• Electrophoresis.

5. The method according to any of the preceding claims 2-4, **characterized in that** said supporting layer is selected from the group consisting of
• Eloxal-layer,
• Ceramic-layer,
• Chromium (VI)-layer and/or
• Corundum-layer.

6. The method according to any of the preceding claims, **characterized in that** the adhesive layer is deposited on the workpiece and/or material by plasma-coating.

7. The method according to any of the preceding claims, **characterized in that** the adhesive layer comprises elements from group 6 and 7 (IUPAC) of the periodic table.

8. The method according to any of the preceding claims, **characterized in that** step b) and/or step c) are carried out under an inert and/or reducing atmosphere.

9. The method according to any of the preceding claims, **characterized in that** in the transition from step b) to step c) the gas supply of at least two different gases is in the form of opposing ramps.

10. The method according to any of the preceding claims, **characterized in that** the reactive gas in step a.2) contains at least temporarily the gases H₂ and O₂.

11. The method according to any of the preceding claims, wherein the method is carried out in a plasma coating chamber comprising a two-dimensional high-frequency electrode for generating an electromagnetic alternating field and a frequency generator located outside the chamber, **characterized in that** the high-frequency electrode is connected to said frequency generator by at least two lines supplying an alternating current voltage.

12. The use of a plasma coating chamber comprising a two-dimensional high-frequency electrode for generating an electromagnetic alternating field, a frequency generator located outside the chamber, and at least two lines, supplying an alternating current voltage from the frequency generator to the high-frequency electrode, for applying a coating to workpieces and/or material according to any of the preceding method claims.

## Revendications

1. Procédé d'application d'un revêtement sur des pièces et/ou sur des matériaux, comportant les étapes suivantes :
a.2) prétraitement ou activation de la pièce et/ou du matériau par pulvérisation cathodique,
b) application d'une couche adhésive ; ainsi que
c) application d'une couche de couverture à résistance élevée par revêtement par plasma, l'alimentation en au moins deux gaz différents s'effectuant à l'étape a.2) sous la forme de rampes en sens contraire et,
a l'étape a.2), outre Ar, au moins l'un des gaz choisi dans le groupe contenant H₂ et/ou O₂ étant utilisé,
H₂ et/ou O₂ étant supplantés par Ar à l'aide des rampes en sens contraire mentionnées ci-dessus.

2. Procédé selon la revendication 1, comportant avant l'étape b) l'étape :
a.1) application d'une couche de support sur la pièce et/ou sur le matériau.

3. Procédé selon la revendication 2, comportant avant l'étape b) au moins une étape du prétraitement ou de l'activation de la couche de support par pulvérisation cathodique.

4. Procédé selon l'une des revendications précédentes 2 ou 3, **caractérisé en ce que** ladite couche de support est appliquée par au moins un procédé choisi dans le groupe :
- projection à la flamme à haute vitesse,
- projection par plasma,
- projection à la flamme,
- anodisation (éloxage), y compris anodisation dure,
- galvanisation,
- revêtement par poudre, et/ou
- électrophorèse.

5. Procédé selon l'une des revendications précédentes 2 à 4, **caractérisé en ce que** ladite couche de support est au moins une couche choisie dans le groupe :
- couche Eloxal,
- couche céramique,
- couche de chrome (VI), et/ou
- couche de corindon.

6. Procédé selon l'une des revendications précédentes, **caractérisé en ce que** la couche adhésive est appliquée au moyen d'un revêtement par plasma sur la pièce et/ou sur le matériau.

7. procédé selon l'une des revendications précédentes, **caractérisé en ce que** la couche adhésive comporte des éléments du groupe 6 et du groupe 7.

8. Procédé selon l'une des revendications précédentes, **caractérisé en ce que** l'étape b) et/ou l'étape c) sont effectuées en atmosphère inerte et/ou réductrice.

9. Procédé selon l'une des revendications précédentes, **caractérisé en ce que** l'alimentation en au moins deux gaz différents s'effectue lors du passage de l'étape b) à l'étape c) sous la forme de rampes en sens contraire.

10. Procédé selon l'une des revendications précédentes, **caractérisé en ce que** le gaz de réaction à l'étape a.2) contient au moins temporairement les gaz H₂ et O₂.

11. procédé selon l'une des revendications précédentes, le procédé étant mis en oeuvre dans une chambre de revêtement par plasma, comportant une électrode plane à haute fréquence pour la production d'un champ électromagnétique alternatif et un générateur de fréquence agencé à l'extérieur de la chambre, **caractérisé en ce que** l'électrode à haute fréquence comporte au moins deux lignes d'alimentation par l'intermédiaire desquelles elle est alimentée avec une tension alternative produite par le générateur de fréquence.

12. Utilisation d'une chambre de revêtement par plasma, comportant une électrode plane à haute fréquence pour la production d'un champ électromagnétique alternatif, un générateur de fréquence agencé à l'extérieur de la chambre ainsi qu'au moins deux lignes d'alimentation par l'intermédiaire desquelles l'électrode à haute fréquence est alimentée avec une tension alternative produite par le générateur de fréquence, pour l'application d'un revêtement sur des pièces et/ou sur des matériaux selon l'une des revendications précédentes.
